# EUROPEAN PATENT APPLICATION

(11) **EP 3 438 519 A1**
(43) Date of publication of application: **06.02.2019**
(21) Application number: 18186262.4
(22) Date of filing: 30.07.2018
(51) Int. Cl.: F21K 9/23, H01L 23/29, H01L 33/56

(54) **LED BULB**

(30) Priority: 31.07.2017 CN 201710643024
(71) Applicant: Zhejiang Emitting Optoelectronic Technology CO., LTD., Jianshan City Zhejiang 314100 (CN)
(72) Inventor: LI, Wenbo, Jianshan City, Zhejiang Province, 314100 (CN); ZOU, Jun, Jianshan City, Zhejiang Province, 314100 (CN); LI, Yang, Jianshan City, Zhejiang Province, 314100 (CN)
(74) Representative: 2K Patentanwälte Blasberg Kewitz & Reichel

(57) **Abstract**

An LED bulb includes a lamp holder, two electrodes arranged in the lamp holder and spaced from each other, and a self-support flexible LED light source disposed between the two electrodes. The self-support flexible LED light source includes at least one flexible substrate, at least one layer of flexible circuit arranged on the flexible substrate, at least one LED chip electrically connected on the flexible circuit, and at least one layer of protective transparent silica gel, two ends of each of at least one layer of the flexible circuit being electrically connected between the two electrodes, the flexible substrate comprising a flexible layer, the flexible layer having a thickness less than 1mm and having a width less than 5mm, the protective transparent silica gel being coated on the at least one LED chip and at least one flexible substrate. The self-support flexible LED light source can maintain any desired formation without any other support structure.

## Description

### RELATED APPLICATION

The present application claims benefit of the Chinese Application, CN201710643024.2, filed on July 31, 2017, the whole content of which is hereby incorporated by reference.

### BACKGROUND

### 1. Technical field

The present invention relates to a lighting device, and more particularly to an LED bulb.

### 2. Description of the related art

In ordinary daily life, all kinds of lighting apparatus can be seen everywhere, such as fluorescent lamps, street lamps, table lamps, artistic lamps and so on. In the above-described lighting apparatus, the tungsten bulb is traditionally used as a light-emitting light source. In recent years, due to the ever-changing technology, light-emitting diode (LED) has been used as a light source. Moreover, in addition to lighting apparatus, for the general traffic signs, billboards, headlights etc., light-emitting diode (LED) has also been used as a light source and obtains a rapid application due to energy consumption, high luminous efficiency and wide application advantages. Therefore, bulb having the LED has been used to replace the tungsten bulb.

For the current light bulb with LED chips, the LED chips are always mounted on a hard circuit board to support it. However, the structural design of such a circuit board with LED chips is unattractive to most people because the design of the light source is inconsistent with people's already formed consumer attitudes. So, light lamp shades of bulbs using this hard circuit board are mostly non-transparent, such as frosted glass, non-transparent plastic, and so on. As a result, it makes the light efficiency lower, and it is difficult to outstand the advantage of the energy-saving and high efficient of the LED chips.

Therefore, it is necessary to provide an LED bulb which makes it possible to solve the above problem.

### BRIEF DESCRIPTION OF THE DRAWINGS

It is an object of the present invention to provide an enhanced LED-bulb, which offers a higher light efficiency and a more attractive design with a cost-efficient configuration that can easily be manufactured.
This problem is solved by a LED-bulb as claimed by claim 1. Further advantageous embodiments are the subject-matter of the dependent claims.
Many aspects of the embodiments can be better understood with references to the following drawings. The components in the drawings are not necessarily drawn to scale, the emphasis instead being placed upon clearly illustrating the principles of the embodiments. Moreover, in the drawings, like reference numerals designate corresponding parts throughout two views.
FIG.1 is a schematic view of an LED bulb according to an embodiment.

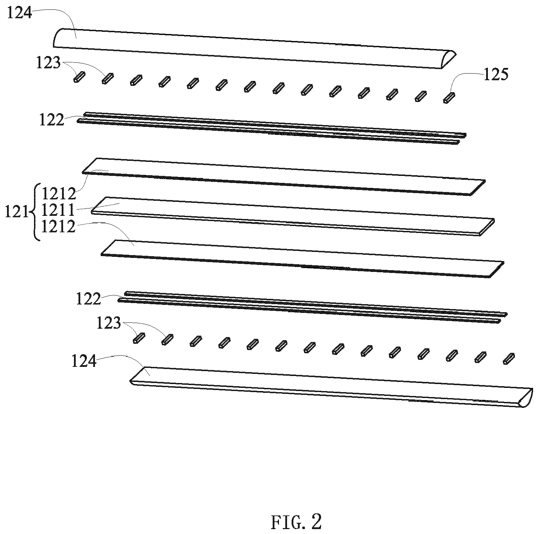

FIG.2 is an explored view of a self-support flexible LED light source of the LED bulb of FIG. 1.
FIG.3 is a schematic view of a previous curved plane two-dimensional structure of the self-support flexible LED light source of the LED bulb of FIG. 1.
FIG.4 is a schematic view of the LED bulb which has a spiral shape.
FIG.5 is a schematic view of the LED bulb which has a W-typed shape.
FIG.6 is a schematic view of the LED bulb which has wavy-typed shape.
FIG.7 is a schematic view of the LED bulb which has two-ring structure.
FIG.8 is a schematic view of the LED bulb which has heart-shaped structure.
FIG.9 is a schematic view of the LED bulb which has bow-knot structure.
FIG.10 is a schematic view of the LED bulb which has U-typed shape.
FIG.11 is a schematic view of the LED bulb which has M-typed shape.

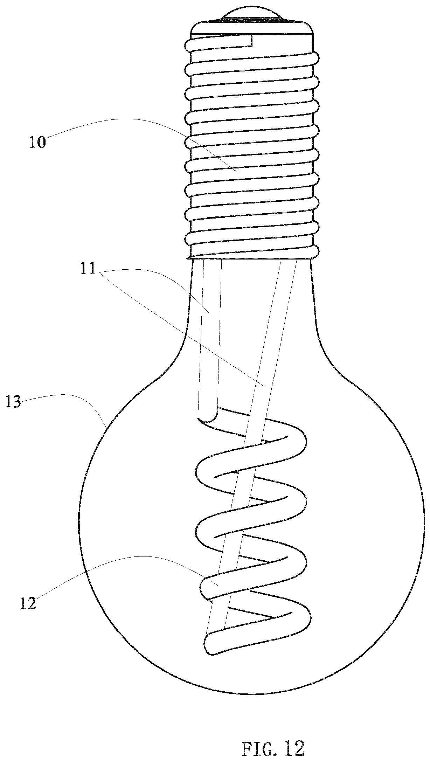

FIG.12 is a schematic view of the LED bulb which has conical snail shape.
FIG.13 is a schematic view of the LED bulb which has a different lamp shade and two electrodes of different lengths.
FIG.14 is a schematic view of the LED bulb in which a self-support flexible LED light source is attached to a lamp shade tightly.

### DETAILED DESCRIPTION

The present application is illustrated by way of example and not by way of limitaion in the figures of the accompanying drawings. It should be noted that references to "an" or "one" embodiment in this application are not necessarily to the same embodiment, and such references mean at least one.

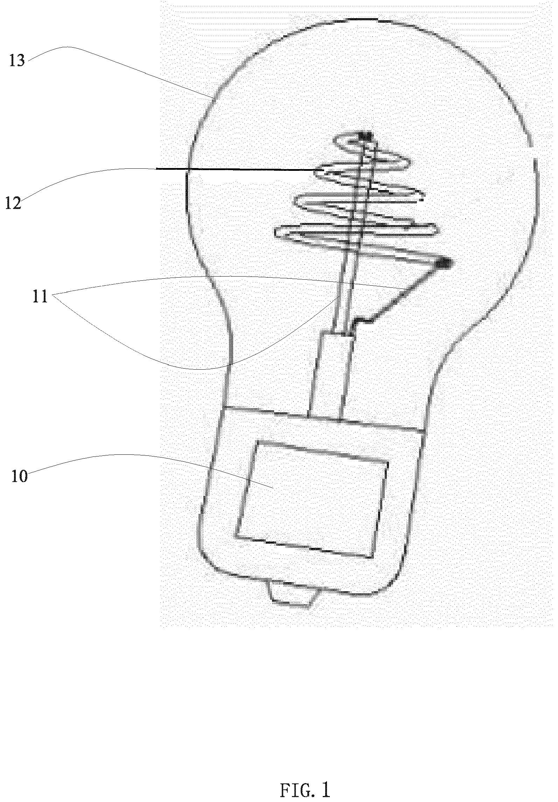

Referring to FIG. 1, an LED bulb is shown in accordance with an examplary emobodiment of the present invention. The LED bulb includes a lamp holder 10, two electrodes 11 arranged on the lamp holder 10 and spaced from each other, a self-support flexible LED light source 12 mounted onto the two electrodes 11, and a lamp shade 13 fixed on the lamp holder 10. It can be understood that the LED bulb further includes other function module, such as welding module, electrical connection module, and so on, which are well known for these skilled in the art and not described in detailed.

The lamp holder 10 is configured for supporting the two electrodes 11 and the lamp shade 13. The lamp holder 10 is provided an external thread on a side wall thereof. The external thread is used to connected to a internal thread of a connector of lamp, such as pendant lamp, or the like. The lamp holder 10 may be made of metal, ceramics, plastic, and so on and may be a cylindrical structure.

The two electrodes 11 are fixed on the lamp holder 10 and spaced from each other for avoiding from short circuit. The two electrodes 11 may have same length or unequal length, which may be further described in detail in specific examples. The two electrodes 11 may be made of conductive metal, such as copper, and so on. One of the two electrodes 11 is positive electrode, and the other is negative electrode.

The self-support flexible LED light source 12 is electrically connected to the two electrodes 11 and includes at least one flexible substrate121, at least one layer of flexible circuit 122 arranged on the flexible substrate 121, at least one LED chip 123 electrically connected on the flexible circuit 122, and at least one layer of protective transparent silica gel 124. As well known for these skilled in the art, the self-support flexible LED light source 12 further includes other function components, such as resistances, inductances, and so on. The flexible substrate 121 includes a flexible layer 1211. The flexible layer 1211 may has a thickness less than 1mm and may has a width less that 5mm. In the present embodiment, the flexible layer 1211 has a thickness of 0.3mm and a width of 4mm. The flexible layer 1211 may be made of metal materials or non-metallic materials. When the flexible layer 1211 is made of metal, such as aluminum, and so on, the flexible substrate 121 further includes at least one insulate layer 1212 coated on the flexible layer 1211 on one side thereof. When the flexible layer 1211 is made of non-metallic material, such as Polyimide or Polyester, the flexible substrate 121 may only includes the flexible 1211. In the present embodiment, the flexible layer 1211 is made of metal material, and the flexible substrate 121 further includes two insulate layers 1212 coated two sides of the flexible 1211 respectively. It can be understood that the self-support flexible LED light source 12 may have two layer of flexible substrates 121 which are overlapped together so as to increase strength thereof.

The flexible circuit 122 may be coated on the flexible substrate 121 by etching process. Etching process should be a know-how technology and no need to explain in detail. The flexible circuit 122 may be made of copper and is configured for providing power for the LED chip 123. The flexible circuit 122 further includes various function wires and even some electronic components such as transistors, diodes, resistors, etc., so that the LED chip 123 can operated normally. Since the flexible substrate 121 only has a width less than 5mm, the flexible circuit 122 has a maximum width which is equal to the width of the flexible substrate 121.

The LED chip 123 serves as a light source for emitting light. It is contemplated that each of the LED chips 122 is a point light source for uniform lighting at the exit angle formed by the primary encapsulation of the LED chip 123. In the present embodiment, the LED chips 122 are arranged in a plurality of rows and equally spaced and the LED chips 122 are provided on the flexible circuit 121. The self-support flexible LED light source 12 may includes one LED chip 123 welded on the flexible circuit 122. Because the self-support flexible LED light source 12 has an arbitrary shape by stretching or curving, the LED chip 123 must be directly welded on the flexible circuit 122. Specifically, a positive electrode and an negative electrode of the LED chip 123 are electrically connected to the flexible circuit 122 directly so as to avoid from failure during stretching or curving. As the flexible substrate 121 has an arbitrary length, the LED chip 123 may have more than one. As a result, the self-support flexible LED light source 12 has a strip-typed shape. Moreover, as the flexible circuit 122 is coated on two sides of the flexible substrate 121, the more LED chips 123 are electrically connected two sides of the flexible substrate 121.

The protective transparent silica gel 124 is coated on the at least one LED chip 123 and at least one flexible substrate 121. In order to obtain different colors of emitted light, the protective transparent silica gel 124 is filled with phosphor. When the LED chip 123 emits blue light, the phosphor is yellow phosphor, and the self-support flexible LED light source 12 emits white light. When the LED chip 123 emits blue light, the phosphor is blue phosphor and red phosphor. And when the LED chip 123 emits purple light, the phosphor is tri-chromatic phosphor. As a result, the self-support flexible LED light source 12 can emit light of any color. After the protective transparent silica gel 124 is coated on the flexible substrate 121, the self-support flexible LED light source 12 may has a circular shape or an ellipse shape in a section perpendicular to the direction of extension thereof. It can be understood that the protective transparent silica gel 124 only is made of silica and has no any phosphor filled therein, and the LED chip 123 may emits various colors of light by themselves.

Since the flexible substrate 121, the flexible circuit 122 and the protective transparent silica gel 124 are flexible by itself, the self-support flexible LED light source 12 can be bent into any shape. As the flexible substrate 121 is made of flexible material and has the thickness less than 1mm, and the thickness of the flexible circuit 122 and the insulate layer 1212 is always very little, only the structure composed of the flexible substrate 121, the flexible circuit 122, and the insulate layer 1212 will hardly support its own weight. That is to say, under its own gravity, the self-support flexible LED light source 12 will be deformed which makes it difficult to form the desired shape. Because it is coated the protective transparent silica gel 124 and the self-support flexible LED light source 12 has a circular section or an ellipse section, the strength of the protective transparent silica gel 124, combined with the strength of the flexible substrate 121, the flexible circuit 122, etc., can support its own weight and achieve self-supporting purposes. That is to say, the self-support flexible LED light source 12 can maintain any desired formation without any other support structure. Before forming the desired shape, the self-support flexible LED light source 12 has a previous curved plane two-dimensional structure, such as spiral ring, straight extension ring, a zigzag pattern, a wavy-typed pattern, and so on. A final shape of the self-support flexible LED light source 12 is formed by stretching from the previous curved plane two-dimensional structure into a curved three-dimensional structure taken along an axial direction of the curved plane dimensional structure.

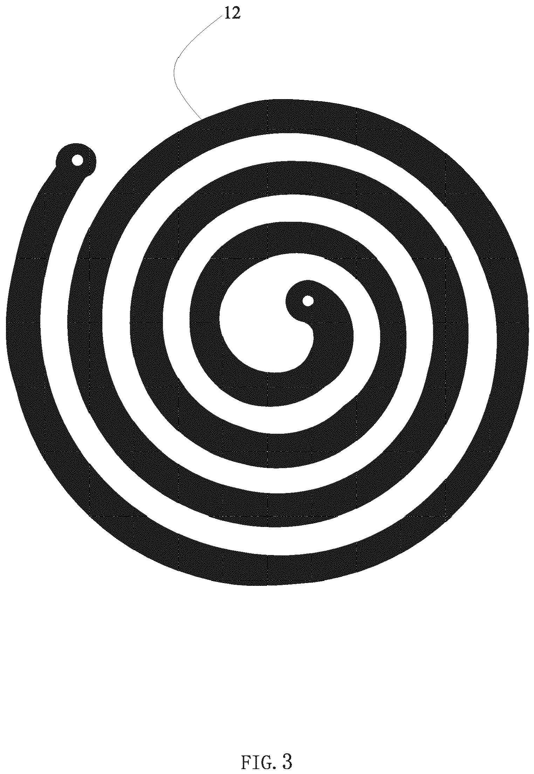

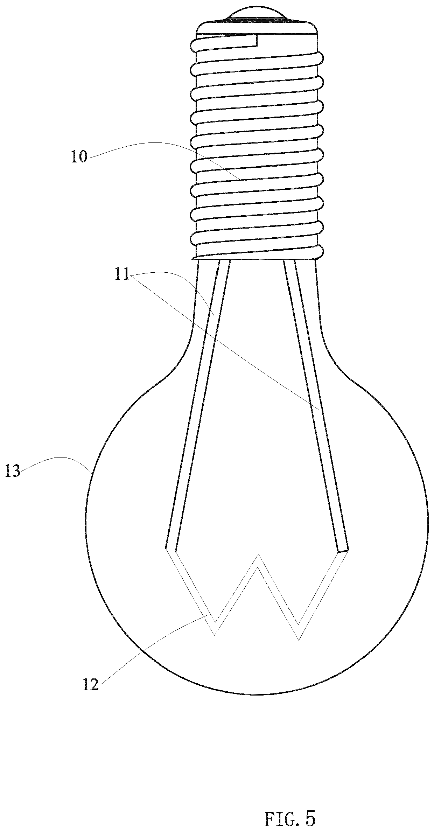

As shown in FIG. 1, it shows a schematic view of the self-support flexible LED light source 12. In this figure, the self-support flexible LED light source 12 has a shape of spiral which is formed by stretching a spiral ring as shown in FIG. 3 taken along an axial direction on the spiral ring. It can be understood that the self-support flexible LED light source 12 may have a shape of arc or an arbitrary shape of an acute angle or an obtuse angle which may be formed by stretching the zigzag pattern. For the acute angle or an obtuse angle shape, as shown in FIG. 5, the self-support flexible LED light source 12 includes at least two branches and the angle between any two adjacent branches is the acute angle or the obtuse angle. It can be understood that the self-support flexible LED light source 12 may have an arbitrary shape of a combination of any two or three of the arc, the spiral, the acute angle, and the obtuse shape, or have a combination of the above shapes by stretching one or more corresponding plane pattern structure.

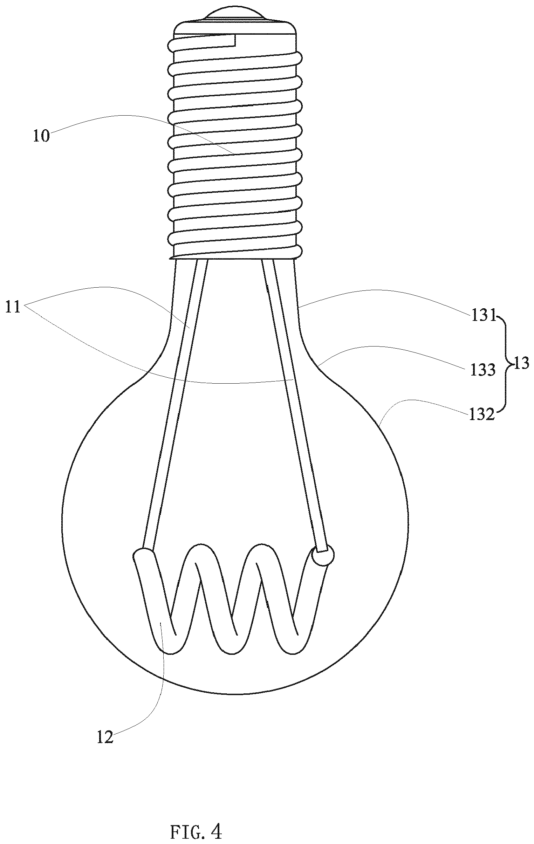

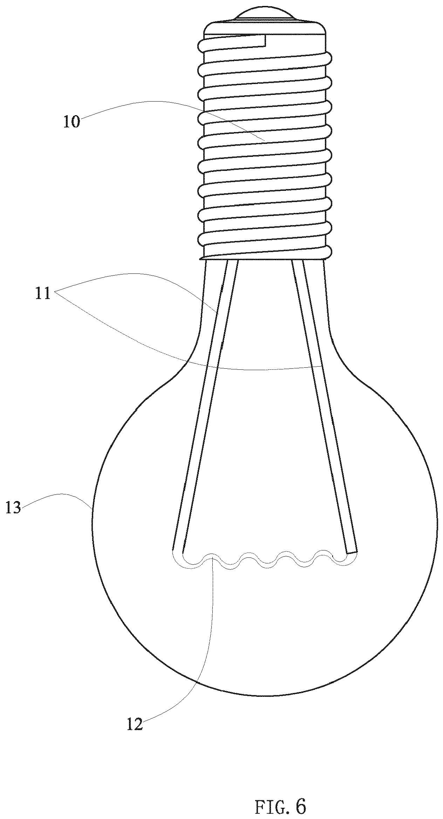

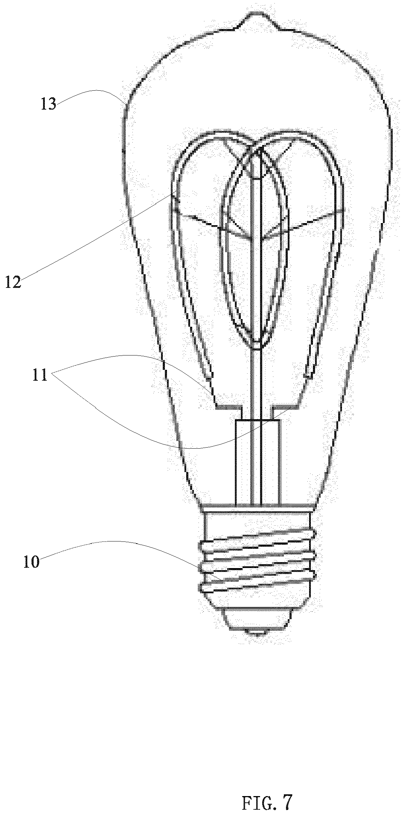

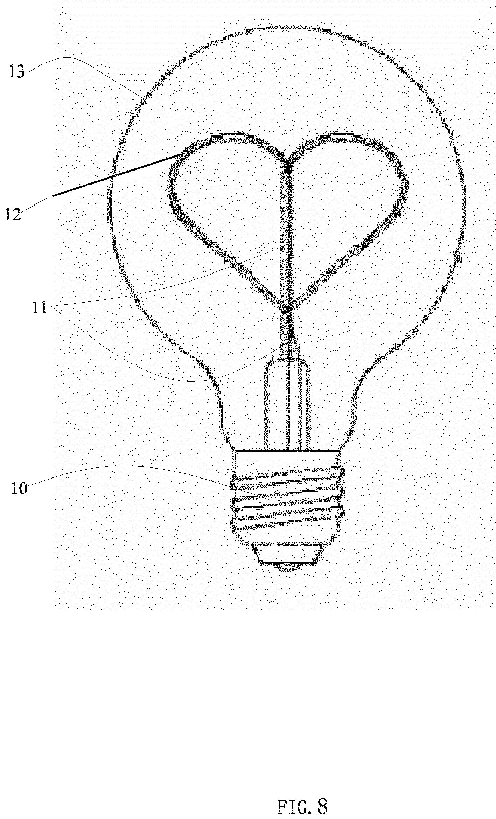

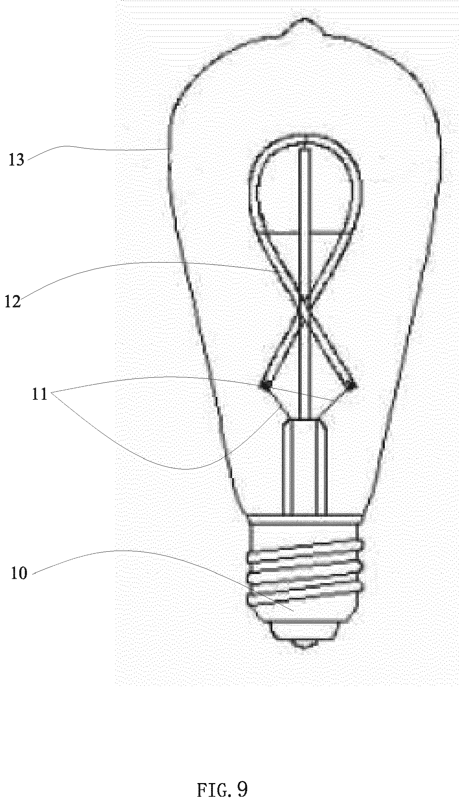

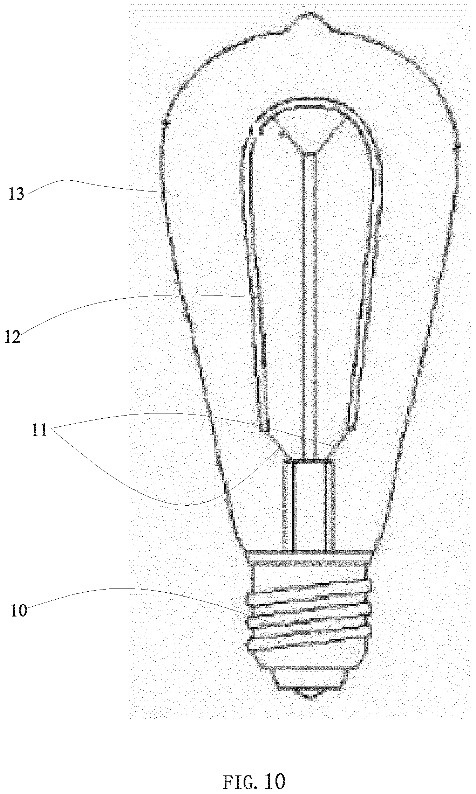

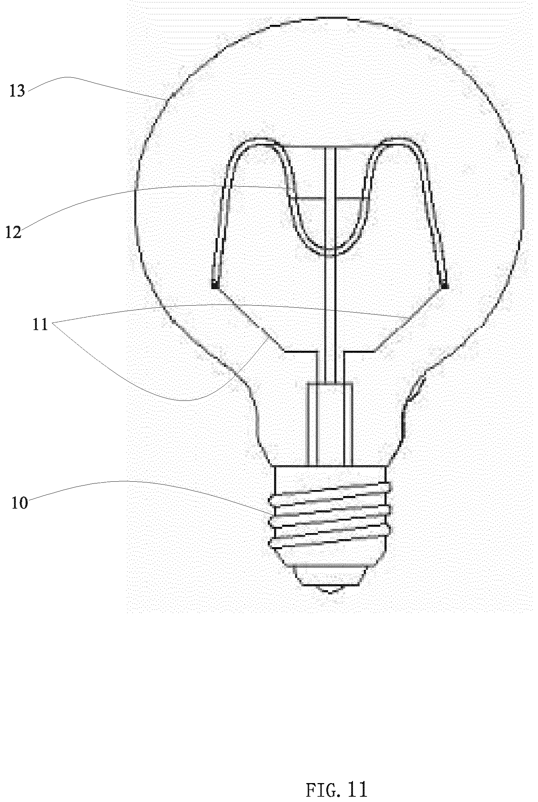

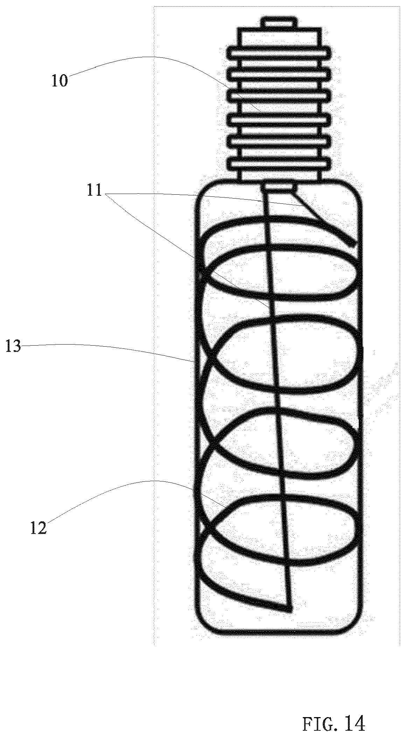

The self-support flexible LED light source 12 may have one or two of V-type structure, W-type structure, or wavy-typed structure. As shown in FIG. 6, the self-support flexible LED light source 12 has the shape of wavy-typed structure. The self-support flexible LED light source 12 has a shape of double-end cone spiral by stretching a double spiral ring. Different shape of the self-support flexible LED light source 12 shown in FIG. 6 to FIG. 11 by stretching different pattern of curved plane structure. In FiG.4, FIG.5, FIG. 6, FIG. 7, FIG. 9, FIG. 10, and FIG. 11, the two electrodes 11 have same length. As shown in FIG. 1, FIG. 8, FIG. 13, and FIG. 14, the two electrodes 11 have unequal length, and the self-support flexible LED light source 12 has a spiral-typed shape which is formed by stretching a straight extension spring and the central axis of the spiral is vertical to the horizontal plane. As shown in FIG. 14, the self-support flexible LED light source 12 is attached to the lamp shade 13 tightly. The self-support flexible LED light source 12 can be attached to the lamp 13 by adhesive or natural expansion so as to optimize the heat dissipation performance of the LED bulb as the lamp shade 13 is bonded to the self-support flexible LED light source 12 to facilitate heat transfer.

The self-support flexible LED light source 12 may further include a drive circuit 125 electrically connected to the flexible substrate 121. The drive circuit 125 is configured for converting AC power to DC power or reducing input voltage. The drive circuit 125 in the LED field is well known for these skilled in the art, and not described in detail. When the self-support flexible LED light source 12 is assembled onto the two electrodes 11, two ends of the self-support flexible LED light source 12 may have two holes and the two electrodes 11 can thread through the two holes respectively. And the two electrodes 11 are welded onto the flexible circuit 122. Moreover, the two ends of the self-support flexible LED light source 12 can be directly welded onto the two electrodes 11 respectively.

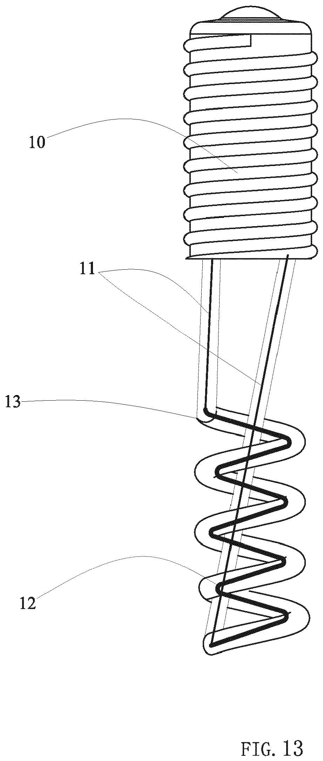

The lamp shade 13 is fixed on the lamp holder 11 and have any shape. In the present embodiment, the lamp shade 13 is made of glass. As shown in FIG. 4, the lamp shade 13 has a cross section having a central symmetrical axis. In one side of the central symmetrical axis, the lamp shade includes a straight segment 131, an arc segment 132, and a transitional arc segment 133 connected between the straight segment 131 and the arc segment 132. And the transitional arc segment 133 is tangent to the straight segment 131 and the arc segment respectively 132. It can be understood that the lamp shade 13 may have other shape, such as cube, cuboid, elliptical cylinder, and so on. In order to obtain certain light effect, the lamp shade 13 may be full with gas therein, such as inert gas, Nitrogen, Iodine steam, and so on or is vacuum in an inside thereof. The lamp shade 13 may be made of transparent material or transparent material only in part. In the present embodiment, the lamp shade 13 is made of transparent material. It can be understood that the lamp shade 13 can be a frosted glass only in part or whole. In other embodiment, as shown in FIG. 13, the lamp shade 13 extends along an extended trajectory of the self-support flexible LED light source 12, which can be formed into various shapes to meet the different needs of users. A distance between the lamp shade 13 and the self-support flexible LED light source 12 is 0mm or greater than 0mm.

As described above, the LED bulb includes the self-support flexible LED light source 12 and the self-support flexible LED light source 12 incldues the flexible substrate 121, the flexible circuit 122, and the protecitive transparent silica gel 124. As a result, the LED bulb can be bent into an arbitrary shape. Although the flexible substrate 121 has a width less than 5mm, the strength of the protective transparent silica gel 124, combined with the strength of the flexible substrate 121, the flexible circuit 122, etc., can support its own weight and achieve self-supporting purposes. That is to say, the self-support flexible LED light source 12 can maintain any desired formation without any other support structure. Moreover, as the shape of the self-supporting flexible LED light source 12 is formed by stretching a curved planar structure taken along the axial direction thereof, the shape thereof is very uniform and smooth, beautiful. Moreover, since the shape of the self-supporting flexible LED light source 12 can be formed by stretching a curved planar structure taken along the axial direction thereof, the self-supporting flexible LED light source 12 can be made into any shape, and the mold is very simple because the former original planar structure is two-dimensional before stretching, not three-dimensional, and it is obvious that this will reduce the manufacturing cost.

While the disclosure has been described by way of example and in terms of exemplary embodiment, it is to be understood that the disclosures is not limited thereto. To the contrary, it is intended to lamp shade various modifications and similar arrangements (as would be apparent to those skilled in the art). Therefore, the scope of the appended claims should be accorded the broadest interpretation so as to encompass all such modifications and similar arrangements.

## Claims

1. An LED bulb, comprising:
a lamp holder;
two electrodes arranged in the lamp holder and spaced from each other; and
a self-support flexible LED light source disposed between the two electrodes, the self-support flexible LED light source comprising
at least one flexible substrate,
at least one layer of flexible circuit arranged on the flexible substrate,
at least one LED chip electrically connected on the flexible circuit, and
at least one layer of protective transparent silica gel,
two ends of each of the at least one layer of the flexible circuit being electrically connected between the two electrodes,
the flexible substrate comprising a flexible layer,
the flexible layer having a thickness less than 1mm and having a width less than 5mm,
a protective transparent silica gel being coated on the at least one LED chip and at least one flexible substrate,
a positive electrode and an negative electrode of the at least one LED chip being electrically connected to the flexible circuit directly, the self-support flexible LED light source,
a shape of the self-support flexible LED light source being formed by stretching from a previously curved plane structure into a curved three-dimensional structure taken along an axial direction of the curved plane structure.

2. The LED bulb as claimed in claim 1, wherein the LED bulb further comprises a lamp shade fixed on the lamp holder, the lamp shade is made of glass or plastic and has any shape, the lamp shade extends along an extended trajectory of the self-support flexible LED light source, a distance between the lamp shade and the self-support flexible LED light source is 0mm or greater than 0mm.

3. The LED bulb as claimed in claim 2, wherein the lamp shade is full with gas therein or is vacuum in an inside thereof.

4. The LED bulb as claimed in claim 2 or 3, wherein the lamp shade is made of transparent material or transparent material only in part.

5. The LED bulb as claimed in any of the preceding claims, wherein the flexible layer is made of metal, and the flexible substrate further comprise at least one insulate layer coated on the flexible layer on one side thereof.

6. The LED bulb as claimed in any of the preceding claims, wherein the previously curved plane structure is a spiral ring, a straight extension spring, a zigzag pattern or a wavy-typed pattern.

7. The LED bulb as claimed in any of the preceding claims, wherein the self-support flexible LED light source has V-typed structure, W-typed structure, or wavy-typed structure.

8. The LED bulb as claimed in any of the preceding claims, wherein the self-support flexible LED light source has an arbitrary shape of an arc, a spiral, an arbitrary shape of an acute angle, an obtuse shape, a combination of any two of the above three, and a combination of the three.

9. The LED bulb as claimed in any of the preceding claims, wherein the self-support flexible LED light source further comprises a drive circuit electrically connected to the flexible substrate.

10. The LED bulb, comprising:
a lamp holder;
a lamp shade fixed on the lamp holder, the lamp shade being made of glass and having an arbitrary shape;
two electrodes arranged on the lamp holder and spaced from each other; and
a self-support flexible LED light source disposed on the two electrodes and comprising
at least one flexible substrate,
at least one layer of flexible circuit arranged on the flexible substrate,
at least one LED chip electrically connected on the flexible circuit, and
at least one layer of protective transparent silica gel,
two ends of each of at least one layer of the flexible circuit being electrically connected between the two electrodes,
the flexible substrate comprising a flexible layer,
the flexible layer having a thickness less than 1mm and having a width less than 5mm,
a protective transparent silica gel being coated on the at least one LED chip and at least one flexible substrate,
a positive electrode and an negative electrode of the at least one LED chip being electrically connected to the flexible circuit directly, the self-support flexible LED light source, and
a shape of the self-support flexible LED light source being formed by stretching from a previously curved plane structure into a curved three-dimensional structure taken along an axial direction of the curved plane structure.

11. The LED bulb as claimed in claim 10, wherein the lamp shade has a cross section having a central symmetrical axis, in one side of the central symmetrical axis the lamp shade comprises a straight segment, an arc segment, and a transitional arc segment connected between the straight segment and the arc segment, the transitional arc segment is tangent to the straight segment and the arc segment respectively.

12. The LED bulb as claimed in claim 10 or 11, wherein the two electrodes have a same length, the self-support flexible LED light source has a spiral-typed shape.

13. The LED bulb as claimed in any of claims 10 to 12, wherein the two ends of the self-support flexible LED light source is welded onto the two electrodes respectively.
